# EUROPEAN PATENT APPLICATION

(11) **EP 1 523 101 A2**
(43) Date of publication of application: **13.04.2005**
(21) Application number: 03257549.0
(22) Date of filing: 01.12.2003
(51) Int. Cl.: H04B 1/04

(54) **Radio transmitter**

(30) Priority: 07.10.2003 GB 0323450
(71) Applicant: Software Radio Technology Limited, Midsomer Norton BA3 4BS, Bath (GB)
(72) Inventor: Cunningham, Andrew, Clifton, Bristol BS8 4HY (GB); Hillum, Richard Arthur, Trowbridge, Wiltshire BA14 0UJ (GB)
(74) Representative: O'Connell, David Christopher

(57) **Abstract**

A radio transmitter includes a power amplifier, and also includes circuitry for determining a relative distortion level in an output signal, for comparing this relative distortion level with a reference distortion level, and for controlling a bias input of the power amplifier on the basis of the comparison.

The bias input can be controlled to make the relative distortion level equal to the reference distortion level, and the reference distortion level can be set on the basis of a required Adjacent Channel Leakage Ratio (ACLR), to ensure that the required ACLR is met, while also ensuring that the power consumption of the device is not unnecessarily increased.

## Description

This invention relates to a radio transmitter, and in particular to a radio transmitter for use in a communications system which requires compliance with specified distortion limits.

The specifications relating to wireless communication systems, such as GSM, UMTS, and others, require that the wireless handsets, operated by network users, must comply with certain standards. For example, it is inevitable that, when a handset is transmitting a signal on a designated channel, there will also be some distortion present on other channels. However, the standards require that this distortion must be kept within strict limits. If this condition is not met, there would be an unacceptable risk that the signals from different handsets would interfere with each other.

Various techniques are known for reducing distortion levels, by linearizing power amplifiers in radio transmitters. However, such techniques typically involve increasing the power consumption of the device, whereas it is advantageous to reduce the power consumption as much as possible, particularly in the case of a battery powered handset.

According to a first aspect of the present invention, there is provided a radio transmitter, including a power amplifier, in which the transmitter comprises means for determining a relative distortion level in an output signal, means for comparing this relative distortion level with a reference distortion level, and means for controlling a bias input of the power amplifier on the basis of the comparison.

This has the advantage that the power consumption of the amplifier can be kept to a minimum, while ensuring compliance with the relevant standard for the distortion level. This has a particular benefit when the transmitter is operating in a radio system under closed loop power control, where the input signal level is regularly changed and the required relative distortion level remains unaltered.
Figure 1 is a block schematic diagram of a radio transmitter in accordance with the first aspect of the present invention.
Figure 2 is a block schematic diagram of the control circuitry in the transmitter of Figure 1.
Figure 3 is a block schematic diagram of an alternative form of control circuitry for use in the transmitter of Figure 1.

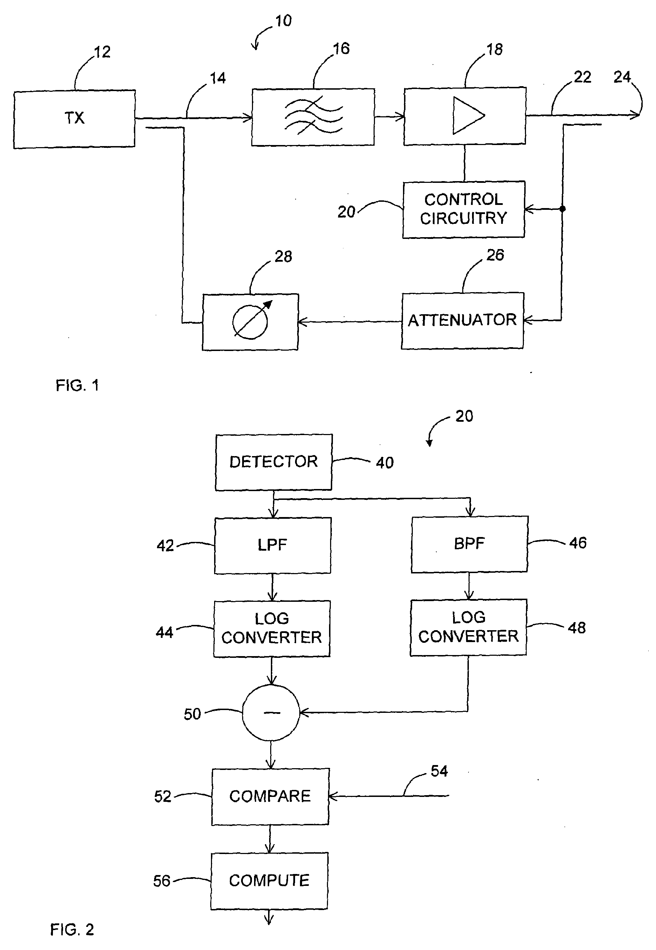

Figure 1 is a block schematic diagram of a radio transmitter 10.

The transmitter 10 includes transmitter circuitry (TX) 12, which, as is conventional, receives an input data signal, and modulates it onto a carrier signal for transmission at radio frequencies over a wireless interface to a receiver (not shown). Any convenient form of modulation may be used, although for the purposes of illustration only, it can be assumed that the transmitter 10 is operating in a UMTS radio communications system.

The radio frequency signals generated by the transmitter circuitry 12 are passed through a coupler 14 to a resonator 16. The resonator 16 takes the form of a tunable circuit, which is tuned to the frequency of the radio frequency signal by means of a control mechanism (not shown), in a manner which is known. The resonator 16 acts as a bandpass filter, and therefore acts to reduce the level of unwanted signals in the transmitter output.

Signals from the resonator 16 are passed to a power amplifier 18, which may be in any conventional form. As is generally conventional, the amplifier 18 acts to amplify the transmitted signals, under the control of a bias signal which is applied to the amplifier. The bias signal is adjusted by control circuitry 20, as will be described in more detail below.

The amplified signals are passed through a second directional coupler 22 to an output 24, which may for example be connected to a transmit antenna (not shown).

A sample of the transmitter output signal is removed by the coupler 22, and is passed to the control circuitry 20. The sample of the transmitter output signal is also passed to an attenuator 26, and to an adjustable loop phase controller 28, which generates a feedback signal.

It should also be noted that, in other embodiments of the invention, a sample of the feedback signal, at the output of the loop phase controller 28, may be passed to the control circuitry 20 instead of the sample of the transmitter output signal.

As is conventional, the attenuator 26 and loop phase controller 28 act to stabilize the feedback loop in the transmitter 10. The resulting feedback signal is subtracted from the input signal in the coupler 14. The feedback loop therefore acts to ensure that the transmitter output signal at the output 24 has the desired output power.

As described so far, with the exception of the control circuitry 20, the transmitter 10 is generally conventional, of a type which is known for example from WO01/89081. It should however be noted that the invention is applicable to any form of linear or linearized transmitter, and, while the invention is particularly suitable to any transmitter which uses feedback linearization, its use is not limited to such transmitters. The same technique is also applicable to transmitters using alternative gain control techniques.

Figure 2 is a block schematic diagram illustrating the form of the control circuitry 20.

The sample of the output signal is supplied to a detector 40, which acts to convert the signal to baseband and detect the signal envelope. The form of the detector 40 is entirely conventional in itself. The detected envelope is applied to a low pass filter 42, which allows only the wanted signal component to pass. The filtered signal is passed to a first log converter 44, which produces an output which is proportional to the logarithm of the filtered signal amplitude.

The detected envelope is also applied to a band pass filter 46, which removes the wanted signal component and produces a signal containing a distortion component of the output signal. If desired, the band pass filter 46 could be replaced by a high pass filter.

This filtered signal is passed to a second log converter 48, which produces an output which is proportional to the logarithm of the filtered signal amplitude.

The outputs from the first and second log converters 44, 48 are passed to a subtractor 50, in which the signal proportional to the logarithm of the distortion component is subtracted from the signal proportional to the logarithm of the wanted component. This produces a signal which is proportional to the difference between the logarithms of the wanted component and the distortion component, and hence is proportional to the ratio of the wanted component to the distortion component.

In some wireless communications systems, for example in the UMTS specifications, the maximum permissible distortion is expressed as a ratio of the wanted signal transmission power. Thus, the UMTS specifications require the Adjacent Channel Leakage Ratio (ACLR) to be better than -33dB at all output power levels.

The output signal of the subtractor 50 is therefore passed to a first input of a comparator 52, while a reference level is passed to a second input 54 of the comparator 52. The reference level corresponds to the ratio set by the appropriate specification, with an appropriate adjustment.

The need for the adjustment may arise because the distortion component measured by the band pass filter 46 and the second log converter 48 need not correspond exactly to the distortion component used in the Adjacent Channel Leakage Ratio measurement. For example, the Adjacent Channel Leakage Ratio may be calculated on the basis of a distortion component in the adjacent channel, with channels being 5MHz wide in UMTS. The adjacent channel typically includes 3^{rd} order intermodulation products of the wanted signal, plus some of the 5^{th} order intermodulation products. However, in a preferred embodiment of the invention, the bandwidth of the band pass filter 46 is set so that the measured distortion component includes only the 3^{rd} order intermodulation products of the wanted signal. This has the advantage that it minimises the required signal processing bandwidth.

In other embodiments, it may be found to be advantageous to set the bandwidth of the band pass filter 46 so that the measured distortion component includes less than all of the 3^{rd} order intermodulation products of the wanted signal, or so that it includes the 3^{rd} order intermodulation products of the wanted signal plus some or all of the 5^{th} order intermodulation products of the wanted signal.

In any of these cases, if the bandwidth of the band pass filter 46 is set so that the measured distortion component includes any more or any less than that used in calculating the Adjacent Channel Leakage Ratio, it follows that the measured power in that component will be correspondingly increased or reduced. The factor by which the measured power is increased or reduced can be determined by appropriate measurements.

Any such change can then be taken into consideration when setting the value of the reference level, which is passed to the second input 54 of the comparator 52.

The result of the comparison in the comparator 52 is then passed to a computation block 56. Based on the comparison result obtained in the comparator 52, the computation block 56 generates a control signal, which is applied to the power amplifier 18. In the preferred embodiments of the invention, the control signal is used to adjust a bias current supplied to the power amplifier, although the power amplifier may be either current or voltage controlled.

For example, if it is determined that the ratio of the wanted signal transmission power to the distortion component power is greater than required by the appropriate specification, the bias current can be reduced. However, if it is determined that the ratio of the wanted signal transmission power to the distortion component power is less than required by the appropriate specification, the bias current can be increased, in order to improve the ratio.

The effect of changing the bias input is to control the operating point of the power amplifier 18, that is, how much distortion the power amplifier will produce for a given level of output signal. Changing the bias input will also tend to change the gain of the power amplifier, but the feedback mechanism acts to counteract any such changes in gain, and so the major effect of changing the bias input is to control the degree of distortion in the power amplifier output signal. Reducing the degree of distortion carries the penalty of a higher power consumption, while a lower power consumption can be achieved at the cost of a greater degree of distortion.

The control circuitry 20 therefore acts to make the measured degree of distortion to be as close as possible to the reference level.

This ensures that the Adjacent Channel Leakage Ratio set by the appropriate specification is always met, but is not exceeded. This therefore also ensures that the bias current, and hence also the power consumption of the power amplifier, are kept as low as possible consistent with that requirement.

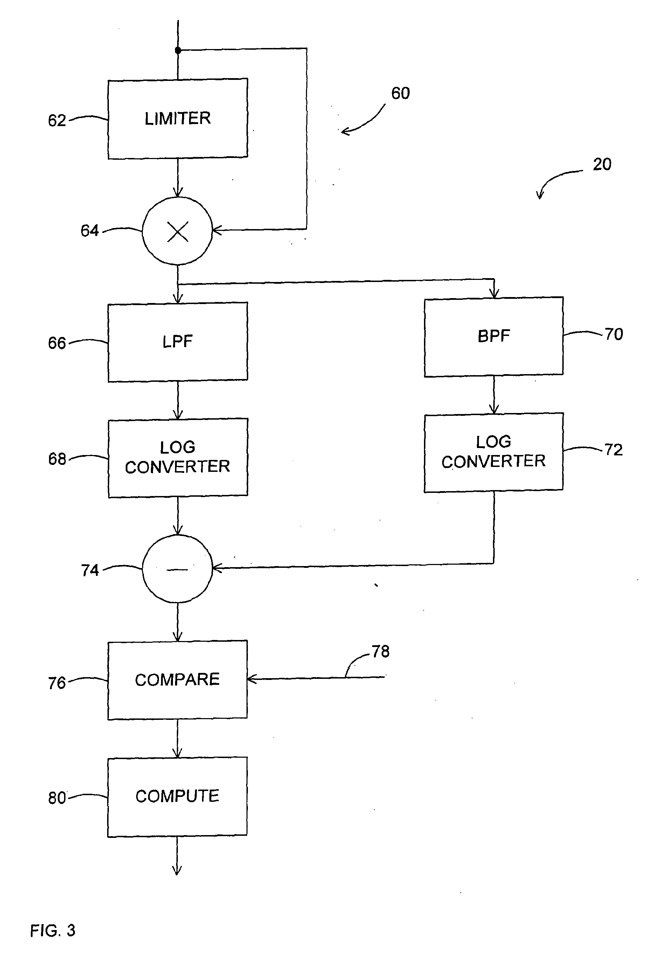

Figure 3 is a block schematic diagram of an alternative form of control circuitry 20.

In this case, the sample of the output signal is supplied to a coherent detector 60. Specifically, the sample of the output signal is applied to a limiter 62 to remove any amplitude variation therein, and to a multiplier 64, in which it is multiplied by the output from the limiter 62. The detector 60 is thus a specific known form of the detector 40 shown in Figure 2. It has the advantages of high dynamic range and low noise.

The detected envelope is applied to a low pass filter 66, which allows only the wanted signal component to pass. The filtered signal is passed to a first log converter 68, which produces an output which is proportional to the logarithm of the filtered signal amplitude.

The detected envelope is also applied to a band pass filter 70, which removes the wanted signal component and produces a signal containing the distortion component of the output signal. If desired, the band pass filter 70 could be replaced by a high pass filter. This filtered signal is passed to a second log converter 72, which produces an output which is proportional to the logarithm of the filtered signal amplitude.

The outputs from the first and second log converters 68, 72 are passed to a subtractor 74, in which the signal proportional to the logarithm of the distortion component is subtracted from the signal proportional to the logarithm of the wanted component. This produces a signal which is proportional to the difference between the logarithms of the wanted component and the distortion component, and hence is proportional to the ratio of the wanted component to the distortion component.

AS described with reference to Figure 2, the output signal of the subtractor 74 is passed to a first input of a comparator 76, while a reference level is passed to a second input 78 of the comparator 76. The reference level corresponds to the ratio set by the appropriate specification.

The result of this comparison is then passed to a computation block 80. Based on the comparison result obtained in the comparator 76, the computation block 80 generates a control signal, which is applied to the power amplifier 18. In the preferred embodiments of the invention, the control signal is used to adjust a bias current supplied to the power amplifier.

As before, if it is determined that the ratio of the wanted signal transmission power to the distortion component power is greater than required by the appropriate specification, the bias current can be reduced. However, if it is determined that the ratio of the wanted signal transmission power to the distortion component power is less than required by the appropriate specification, the bias current can be increased, in order to improve the ratio. This ensures that the Adjacent Channel Leakage Ratio set by the appropriate specification is always met, but not exceeded, so that the bias current, and hence also the power consumption of the power amplifier, are kept as low as possible consistent with that requirement.

In the illustrated embodiment of the invention shown in Figure 1, a directional coupler 22 is used to obtain a sample of the output signal. However, the sample could be obtained in other ways, for example by converting the output signal from analog to digital form, and then using a copy of the resulting digital signal in the control circuitry 20.

In the illustrated embodiments of the invention shown in Figures 2 and 3, low pass filters 42, 46 are used to isolate the wanted signal component of the output signal. Alternatively, it would be possible not to filter this signal, but instead to compare the power of the distortion component with the power of the whole output signal, comprising the wanted component and the distortion component. This would produce effectively the same information, provided that a suitably adjusted reference distortion level is used.

As described above, the control signal produced by the computation block 56, 80 is used to adjust a bias current supplied to the power amplifier. This can be achieved by integrating the comparison output in a loop filter, and using the resulting integrated output to control the bias current. Alternatively, the comparison result can be fed into a mathematical model of the power amplifier bias pin control characteristics, so that the dynamic characteristics of the feedback loop are essentially linear.

There is therefore described a radio transmitter, which ensures compliance with specified distortion limits required in a communications system.

## Claims

1. A radio transmitter, including a power amplifier, in which the transmitter comprises means for determining a relative distortion level in an output signal, means for comparing this relative distortion level with a reference distortion level, and means for controlling a bias input of the power amplifier on the basis of the comparison.

2. A radio transmitter as claimed in claim 1, comprising means for determining a distortion level in said output signal, and means for determining the relative distortion level from said distortion level.

3. A radio transmitter as claimed in claim 2, comprising means for determining a wanted signal level in said output signal, and means for determining the relative distortion level from said distortion level and said wanted signal level.

4. A radio transmitter as claimed in claim 3, comprising means for generating a first signal proportional to a logarithm of the wanted signal level, means for generating a second signal proportional to a logarithm of the distortion level, and means for determining the relative distortion level by subtracting said second signal from said first signal.

5. A radio transmitter as claimed in claim 2, comprising means for determining a signal level of said output signal, and means for determining the relative distortion level from said distortion level and said signal level of said output signal.

6. A radio transmitter as claimed in claim 5, comprising means for generating a first signal proportional to a logarithm of the output signal level, means for generating a second signal proportional to a logarithm of the distortion level, and means for determining the relative distortion level by subtracting said second signal from said first signal.

7. A radio transmitter as claimed in any preceding claim, wherein the means for controlling the bias input acts to make the determined relative distortion level substantially equal to the reference distortion level.

8. A radio transmitter as claimed in any preceding claim, wherein the means for determining a relative distortion level comprises means for determining a distortion level in a distortion frequency band.

9. A radio transmitter as claimed in claim 8, wherein the reference distortion level is set on the basis of a specified Adjacent Channel Leakage Ratio for the radio transmitter, and on the basis of any difference between bandwidths of an adjacent channel and of the distortion frequency band.

10. A radio transmitter as claimed in any preceding claim, comprising a feedback loop, wherein the feedback loop operates to control a transmitter output power, such that a gain of the transmitter is insensitive to changes in the bias input.
